(19) Europäisches Patentamt / European Patent Office / Office européen des brevets

(11) **EP 1 753 145 A2**

(12) **EUROPÄISCHE PATENTANMELDUNG**

(43) Veröffentlichungstag:
**14.02.2007 Patentblatt 2007/07**

(21) Anmeldenummer: **06118499.0**

(22) Anmeldetag: **07.08.2006**

(51) Int Cl.:
*H04B 1/04* (2006.01)   *H03F 1/32* (2006.01)

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **11.08.2005 DE 102005038122**

(71) Anmelder: **SIEMENS AKTIENGESELLSCHAFT 80333 München (DE)**

(72) Erfinder:
• **Wolff, Gunter**
  **89081, Ulm (DE)**
• **Jelonnek, Björn**
  **89079, Ulm (DE)**

(54) **Verfahren und Anordnung zur Vorverzerrung eines Basisband-Eingangssignals**

(57)   Die Erfindung betrifft ein Verfahren zur Vorverzerrung eines Basisband-Eingangssignals (BB-IN1), bei dem das komplexe Basisbandeingangssignal (BB-IN1) mit einer Funktion $H_1(f)$ zur Bildung eines gefilterten ersten Signals (IPF1-OUT) gefiltert wird. Das gefilterte erste Signal (IPF1-OUT) wird zur Bildung eines vorverzerrten Signals (MUL-OUT) im Basisband mit einem Skalierungsfaktor (SKAL) multipliziert. Durch eine Signalanalyse des gefilterten ersten Signals (IPF1-OUT) werden Signalüberschreitungen vorhergesagt, aus denen der Skalierungsfaktor für die Basisband-Vorverzerrung bestimmt wird. Die Filterfunktion $H_1(f)$ wird als Quotient aus einem Frequenzgang $H_S(f)$ eines verwendeten Sendefilters einerseits und aus einem Fehlerfrequenzgang $H_F(f)$ andererseits berechnet, wobei der Fehlerfrequenzgang $H_F(f)$ derart bestimmt wird, dass der mit $H_F(f)$ spektral geformte Fehler, der bei der Begrenzung des Basisbandsignals entsteht, eine frequenzabhängige Toleranz nicht überschreitet. Anschließend wird das vorverzerrte Signal (MUL-OUT) mit dem Fehlerfrequenzgang $H_F(f)$ zur Bildung eines gefilterten zweiten Signals gefiltert.

FIG 2A

EP 1 753 145 A2

# FIG 2B

**Beschreibung**

Die Erfindung betrifft ein Verfahren sowie eine Anordnung zur Vorverzerrung eines komplexen Basisband-Eingangssignals, insbesondere von Basisband-Eingangssignalen eines Mehrfachträger-Übertragungssystems.

Bei mobilen Funkkommunikationssystemen werden höherwertige Modulationsverfahren verwendet, bei denen Symbole mit mehr als zwei möglichen Informationszuständen übertragen werden.

Zu diesen Modulationsverfahren gehören beispielsweise die bekannten Modulationsverfahren QPSK, 8PSK und 16QAM, bei denen zur Erzielung einer höheren Datenübertragungsrate auf eine konstante Einhüllende einer Momentan-Sendeleistung eines trägerfrequenten Sendesignals verzichtet wird. Damit variiert eine Momentan-Sendeleistung im zeitlichen Verlauf.

Eine Variation der Momentan-Sendeleistung ist auch in Mehrfachträgerübertragungssystemen bekannt, bei denen Signale beispielsweise mittels einer OFDM-Funkübertragung unter Verwendung von Einzelträgern (Subcarrier) gesendet werden.

In Abhängigkeit von dem jeweils verwendeten Modulationsverfahren und der Kombination von jeweils verwendeten Einzelträgern kann eine betrachtete, augenblickliche Maximalleistung eines Sendesignals wesentlich über einem Mittelwert der Sendeleistung liegen. Das Verhältnis der maximalen Sendeleistung zur mittleren Sendeleistung wird als "peak to average ratio, PAR" oder als "peak to average power ratio, PAPR" bezeichnet, wobei im oben genannten Fall gilt: PAR > 1 bzw. PAPR > 1.

Bei einem derartigen PAR-Wert ist seitens eines verwendeten Sendeverstärkers eine so genannte "Aussteuerungsreserve" vorzuhalten, um nichtlineare Verzerrungen des Sendesignals durch den Sendeverstärker zu vermeiden. Durch diese Notwendigkeit wird die Komplexität und der Leistungsverbrauch des Sendeverstärkers erhöht und gleichzeitig ein Wirkungsgrad eines betrachteten gesamten Sendesystems verringert.

Es sind Vorverzerrungs- bzw. "Clipping-" Verfahren bekannt, mit deren Hilfe der Einfluss einer nichtlinearen Kennlinie des Sendeverstärkers auf ein verstärktes trägerfrequentes Sendesignal in gewissen Maßen kompensiert werden kann.

Durch Anwendung derartiger Clipping-Verfahren ist es möglich, die seitens des Sendeleistungsverstärkers vorzuhaltende Aussteuerungsreserve zu minimieren.

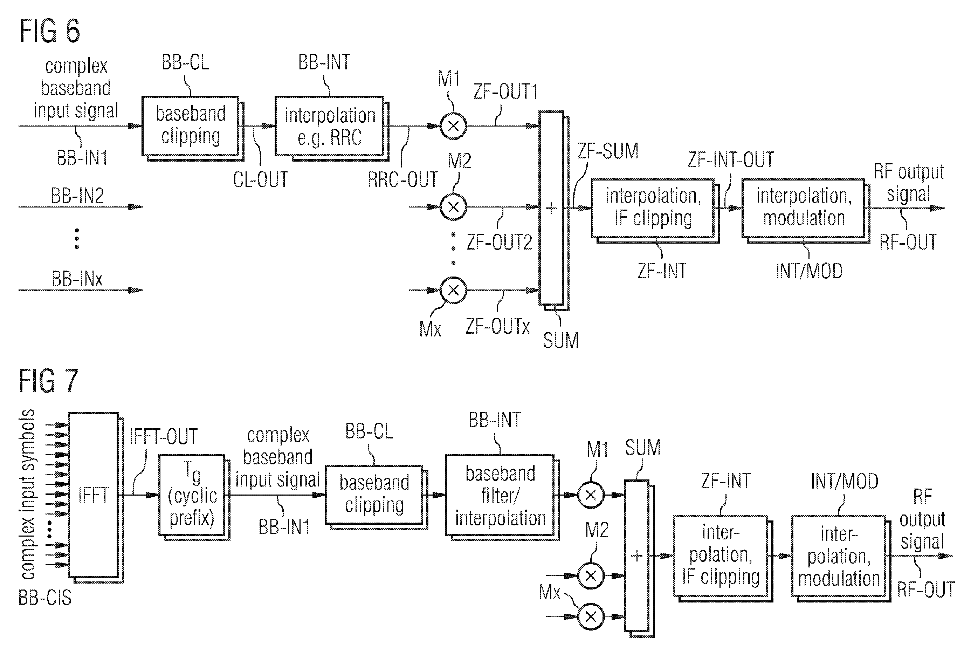

FIG 6 zeigt eine Bildung eines zu sendenden hochfrequenten Ausgangssignals RF-OUT gemäß dem Stand der Technik in einer vereinfachten Darstellung.

Dabei wird ein komplexes Basisband-Eingangssignal BB-IN1 einer Basisband-Clipping-Einheit BB-CL zugeführt. Ein dabei gebildetes, vorverzerrtes Ausgangssignal CL-OUT wird eingangsseitig einer Interpolationseinheit BB-INT zugeführt. Die Interpolationseinheit BB-INT ist beispielsweise als "Root Raised Cosine, RRC"-Filter ausgebildet und wird zur Bandbreitenbegrenzung verwendet.

Ein durch die Interpolationseinheit BB-INT gebildetes Ausgangssignal RRC-OUT wird einem Mischer M1 zugeführt, der das zugeführte Signal mit einer hohen Abtastrate abtastet und in eine Zwischenfrequenzlage ZF umsetzt, so dass ein Ausgangssignal ZF-OUT1 gebildet wird. Durch den Mischer M1 wird ein Frequenzversatz beim Ausgangssignal ZF-OUT1 gebildet.

Auf gleiche Weise werden weitere komplexe Basisband-Eingangssignale BB-IN2 bis BB-INx in weiteren x-1 Parallelzweigen in zwischenfrequente Signale ZF-OUT2 bis ZF-OUTx umgewandelt.

Nachfolgend werden die zwischenfrequenten Signale ZF-OUT1 bis ZF-OUTx in einer Summiereinheit SUM additiv überlagert und zu einem zwischenfrequenten Summensignal ZF-SUM zusammengefasst.

Das Summensignal ZF-SUM wird einer Einheit ZF-INT zugeführt und dort sowohl interpoliert ("interpolation") als auch in der ZF-Lage vorverzerrt ("IF-clipping"), so dass ein zwischenfrequentes Ausgangssignal ZF-INT-OUT gebildet wird.

Das Ausgangssignal ZF-INT-OUT wird einer Einheit INT/MOD zugeführt, die es sowohl interpoliert ("interpolation") als auch durch Modulation ("modulation") in eine Trägerfrequenzlage RF umsetzt, so dass ein trägerfrequentes Ausgangssignal RF-OUT gebildet wird.

Beim Clipping-Verfahren im Basisband mittels der Basisband-Clipping-Einheit BB-CL wird ein verzerrtes Ausgangssignal CL-OUT gebildet, das jedoch aufgrund des nachgeschalteten RRC-Filters keine zum Nutzsignalband benachbarten Frequenzbänder beeinflusst.

Beim Clipping-Verfahren im Zwischenfrequenzbereich ZF, das mittels der Einheit ZF-INT erfolgt, können durch entstehende maximale Signalamplituden zusätzliche Störungen in den Nachbarfrequenzbändern verursacht werden.

Damit sich daraus keine unzulässige Verschlechterung des Verhältnisses "adjacent channel leakage ratio, ACLR" ergibt, müssen diese Störungen der Nachbarfrequenzbänder mit entsprechenden Filtern unterdrückt werden. diese Filter wirken vorteilhafterweise auf das analoge Hochfrequenzsignal.

Beim so genannten "rechteckigen" Clipping-Verfahren werden Inphase-Komponente und Quadratur-Komponente des komplexen Signals unabhängig voneinander begrenzt.

Beim so genannten "zirkularen" Clipping-Verfahren überschreitet ein Betrag eines komplexen Signals im Basisband einen vorgegebenen maximalen Signalwert nicht.

FIG 7 zeigt eine Bildung eines trägerfrequenten Ausgangssignals bei einem Funkkommunikationssystem mit Multiträgern gemäß dem Stand der Technik in einer vereinfachten Darstellung.

Beispielhaft wird hier ein OFDM-Funkkommunikationssystem betrachtet. Dabei werden komplexe Basisband-Eingangssignale BB-CIS einer Einheit IFFT zugeführt, mit deren Hilfe eine inverse Fast-Fourier-Transformation durchgeführt wird.

Die komplexen Basisband-Eingangssignale BB-CIS werden zu einem komplexen Ausgangssignal IFFT-OUT umgeformt. Nachfolgend werden zeitliche Schutzintervalle durch eine Einheit Tg eingefügt und ein komplexes Basisband-Eingangssignal BB-IN1 gebildet. Die Schutzintervalle werden zur Unterdrückung von Intersymbol-Interferenzen zwischen den Symbolen eingefügt.

Mit Bezug auf FIG 6 wird dann auf entsprechende Art und Weise ein trägerfrequentes Ausgangssignal RF-OUT gebildet.

Es ist Aufgabe der vorliegenden Erfindung, für eine Funkübertragung, bei der insbesondere Einzelträger bzw. Subcarrier verwendet werden, eine Anordnung und ein Verfahren für eine Vorverzerrung anzugeben, mit der das Verhältnis von maximaler Momentanleistung zur mittleren Leistung (PAPR) eines digitales komplexes Basisband-Eingangssignal ohne Signalqualitätseinbußen verringert werden kann.

Diese Aufgabe wird durch die Merkmale der Patentansprüche 1 und 10 gelöst. Vorteilhafte Weiterbildungen sind in den jeweiligen Unteransprüchen angegeben.

Durch die vorliegende Erfindung ist es möglich, eine vorzuhaltende Aussteuerungsreserve eines Verstärkers zu reduzieren.

Durch die vorliegende Erfindung ist es auch möglich, eine erforderliche DA-Wandler-Auflösung zu reduzieren, da der D/A-Wandler Signalspitzen nicht mehr darstellen bzw. auflösen muss.

Mit Hilfe der vorliegenden Erfindung ist es möglich, Sendesignale im digitalen komplexen Basisband in der Amplitude zu begrenzen, ohne dabei störende Einbußen hinsichtlich der Sendesignalqualität hinnehmen zu müssen.

Mit Hilfe der vorliegenden Erfindung werden Sendeleistungs-Maximalwerte reduziert, wodurch ein Sendeleistungsverstärker mit geringerem Stromverbrauch eingesetzt werden kann.

Alternativ oder ergänzend dazu kann auch die mittlere Sendeleistung erhöht werden. Aufgrund der erhöhten mittleren Sendeleistung kann außerdem eine erhöhte Reichweite erzielt werden.

Nachfolgend wird die Erfindung anhand einer Zeichnung näher erläutert. Dabei zeigt:

FIG 1  eine Bildung des trägerfrequenten Ausgangssignals gemäß der vorliegenden Erfindung in einer vereinfachten Darstellung,

FIG 2  eine detaillierte Darstellung von in FIG 1 gezeigten Einheiten zur Bildung eines komplexen Basisband-Ausgangssignals,

FIG 3  mit Bezug auf FIG 2 eine Kaskade zur Bildung eines komplexen Basisband-Ausgangssignals,

FIG 4  eine spezielle Implementierungsform der in FIG 2 ge-zeigten detaillierten Darstellung,

FIG 5  eine Bildung des trägerfrequenten Ausgangssignals gemäß der vorliegenden Erfindung in einer alternativen Ausgestaltungsform,

FIG 6  die in der Beschreibungseinleitung beschriebene Bildung eines zu sendenden hochfrequenten Ausgangssignals gemäß dem Stand der Technik,

FIG 7  die in der Beschreibungseinleitung beschriebene Bildung eines trägerfrequenten Ausgangssignals bei einem Funk-kommunikationssystem mit Multiträgern gemäß dem Stand der Technik in einer vereinfachten Darstellung.

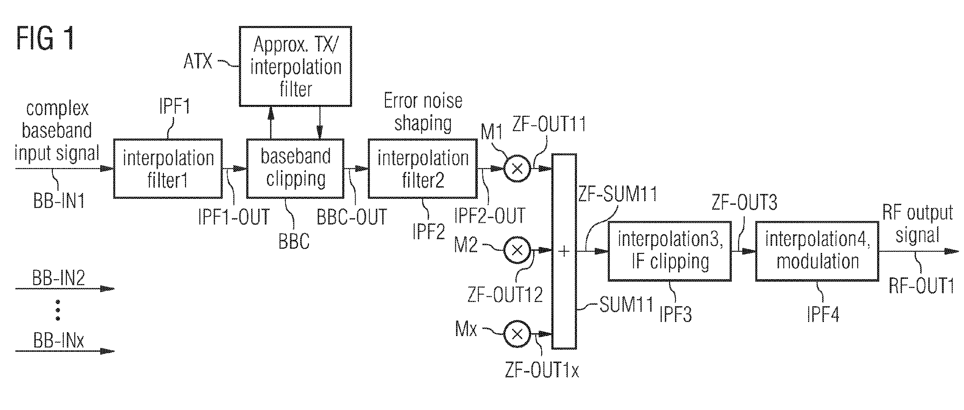

FIG 1 zeigt eine Bildung des trägerfrequenten Ausgangssignals gemäß der vorliegenden Erfindung in einer vereinfachten Darstellung.

Dabei wird ein komplexes Basisbandeingangssignal BB-IN1 einem ersten Interpolationsfilter IPF1 zugeführt. Dessen Ausgangssignal IPF1-OUT wird nachfolgend eine Einheit BBC zugeführt, die im Basisband ein Clipping-Verfahren am zugeführten Signal IPF1-OUT durchführt.

Bei diesem Clipping-Verfahren wird eine Einheit ATX verwendet, die mit der Einheit BBC in wechselseitiger Verbindung steht und die als so genanntes "approximative TX and interpolation filter" ausgebildet ist.

Mit Hilfe der Einheit ATX werden die beim Basisband-Clipping-Verfahren entstehenden voraussichtlichen Schwellwertüberschreitungen des Signals ausgewertet und zur Begrenzung des Signals verwendet.

Ein durch die Einheit BBC gebildetes Ausgangssignal BBC-OUT wird einem Interpolationsfilter IPF2 zugeführt, mit dessen Hilfe ein so genanntes "error noise shaping" erfolgt.

Zusammengefasst werden dabei sowohl das zugeführte Signal BBC-OUT als auch ein beim Clipping in der Einheit BBC entstandener Fehler spektral geformt. Dieser Fehler würde ansonsten eine zulässige Frequenzmaske verletzen, da er wesentlich breitbandiger ist, als ein erwartetes Nutzsignal. Um Störungen außerhalb des Nutzbandes auf andere Signale zu vermeiden, muss der Anteil außerhalb des Nutzbandes durch Filterung entfernt werden. Mit Hilfe des Interpolationsfilters IPF2 wird der Fehler spektral geformt und so an eine Toleranz in jedem Multiträger-Frequenzbereich angepasst.

Es werden sowohl Signal als auch die Signalabweichungen bzw. Fehler gefiltert.

Ein durch die Einheit IPF2 gebildetes Ausgangssignal IPF2-OUT wird einem Mischer M1 zugeführt und in eine Zwischenfrequenzlage ZF zu einem Signal ZF-OUT11 umgesetzt.

Auf gleiche Weise werden weitere komplexe Basisband-Eingangssignale BB-IN2 bis BB-INx in insgesamt x-1 Parallelzweigen in zwischenfrequente Signale ZF-OUT12 bis ZF-OUT1x umgewandelt.

Nachfolgend werden die zwischenfrequenten Signale ZF-OUT11 bis ZF-OUT1x in einer Summiereinheit SUM11 additiv überlagert und zu einem zwischenfrequenten Summensignal ZF-SUM11 zusammengefasst.

Das Summensignal ZF-SUM11 wird einer Einheit IPF3 zugeführt und dort sowohl interpoliert ("interpolation3") als auch in der ZF-Lage vorverzerrt ("IF-clipping"), so dass ein zwischenfrequentes Ausgangssignal ZF-OUT3 gebildet wird.

Das Ausgangssignal ZF-OUT3 wird einer Einheit IPF4 zugeführt, die es sowohl interpoliert ("interpolation4") als auch durch Modulation ("modulation") in eine Trägerfrequenzlage RF umsetzt, so dass ein trägerfrequentes Ausgangssignal RF-OUT1 gebildet wird.

Mit Hilfe der vorliegenden Erfindung ist es möglich, bei einem gleichen Störpegel innerhalb des Signals, wie er beispielsweise durch den "error vector magnitude, EVM"-Wert beschrieben wird, eine Verringerung des "peak to average ratio, PAR" zu erzielen.

Mit Hilfe der vorliegenden Erfindung ist es möglich, kostengünstige Verstärker, die über einen größeren Bereich keine hochlineare Verstärkerkennlinie aufweisen, als Sendeleistungsverstärker zu verwenden.

Es werden komplexe, d.h. reelle und imaginäre Signalanteile gleichzeitig umgesetzt, weshalb FIG 1 zu jeder benannten Einheit jeweils eine nicht näher bezeichnete weitere, hinterlegte Einheit aufweist.

Zu beachten ist, dass viele Operationen echt komplexzahlig ausgeführt werden, bei denen die Inphase-Komponente I und die Quadraturkomponente Q zueinander in Beziehung stehen.

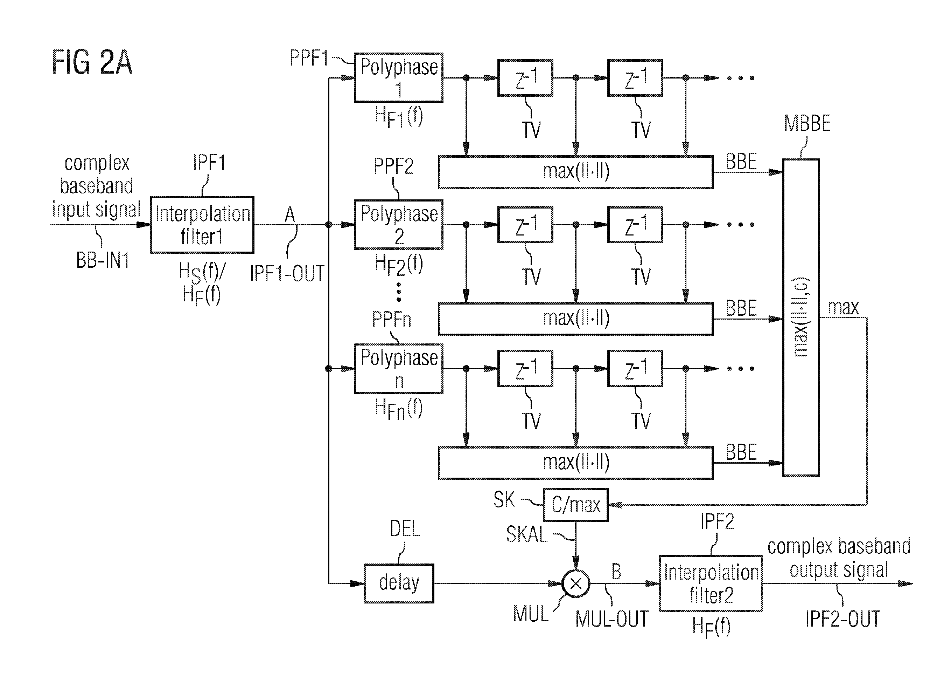

FIG 2a zeigt eine detailliertere Darstellung der in FIG 1 gezeigten Einheiten IPF1, BBC, ATX und IPF2 zur Bildung des ebenfalls in FIG 1 gezeigten komplexen Basisband-Ausgangssignals IPF2-OUT.

Die Einheit IPF2 ist als Interpolationsfilter mit vorab festgelegtem Fehlerfrequenzgang $H_F(f)$ ausgebildet, mit dem auch ein beim Clippen entstehender Fehler gefiltert wird.

Bei der Bestimmung des Fehlerfrequenzgangs $H_F(f)$ wird davon Gebrauch gemacht, dass außerhalb eines verwendeten Nutz-Frequenzbereichs ein größerer Fehler tolerierbar ist, als innerhalb des Nutz-Frequenzbereichs. Dabei muss gleichzeitig das Fehlersignal außerhalb des Nutz-Frequenzbereichs so stark gedämpft werden, dass dort unzulässige Störungen nicht auftreten können.

Zur spektralen Formung des Fehlers kann ein invertierter Frequenzgang eines Gegenstellen-Empfängers unter Berücksichtigung der jeweiligen Bandgrenzen des Nutz-Frequenzbereichs verwendet werden. Dadurch wird erreicht, dass der Fehler im Gegenstellen-Empfangssignal nach Passieren eines Empfangsfilters gleichverteilt im Frequenzspektrum vorliegt.

Alternativ dazu kann auch ein anderer Frequenzgang verwendet werden. In allen Fällen ist sicherzustellen, dass außerhalb des verwendeten Nutz-Frequenzbereichs keine unzulässigen Störungen auftreten.

Der Fehlerfrequenzgang $H_F(f)$ wird vorteilhafterweise beim Filter, das sich aus allen nachfolgend beschriebenen Polyphasenfiltern PPF1 bis PPFn zusammensetzt, und bei der Einheit IPF2 verwendet.

Die Einheit IPF1 weist einen Frequenzgang $H_1(f)$ auf, der aus einem Frequenzgang $H_S(f)$ eines verwendeten Sendefilters und aus dem Fehlerfrequenzgang $H_F(f)$ wie folgt bestimmt wird:

$$H_1(f) \; = \; H_S(f) \; / \; H_F(f)$$

Das Eingangssignal BB-IN1 wird durch die Einheit IPF1 mit dem Frequenzgang $H_1(f)$ versehen.

Das Ausgangssignal IPF1-OUT wird einer Anzahl an Polyphasenfiltern PPF1 bis PPFn übergeben, die jeweilige Fehlerfrequenzgänge $H_{F1}(f)$ bis $H_{Fn}(f)$ aufweisen.

In den Polyphasenfiltern PPF1 bis PPFn kann zusätzlich eine Überabtastung des zugeführten Signals IPF1-OUT mit einem Faktor K erfolgen, der vorteilhaft mit K=2 gewählt wird.

Jedem einzelnen der Polyphasenfilter PPF1 bis PPFn ist jeweils eine Anzahl an Einheiten TV zur zeitlichen Verzögerung sowie genau eine Einheit BBE zur Betragsbildung nachgeschaltet. Mit deren Hilfe wird ein Maximum aus Signalbeträgen innerhalb eines zeitlichen Intervalls gebildet. Das Intervall ergibt sich dabei aus der Länge der Verzögerungskette bzw. aus der Anzahl der Einheiten TV.

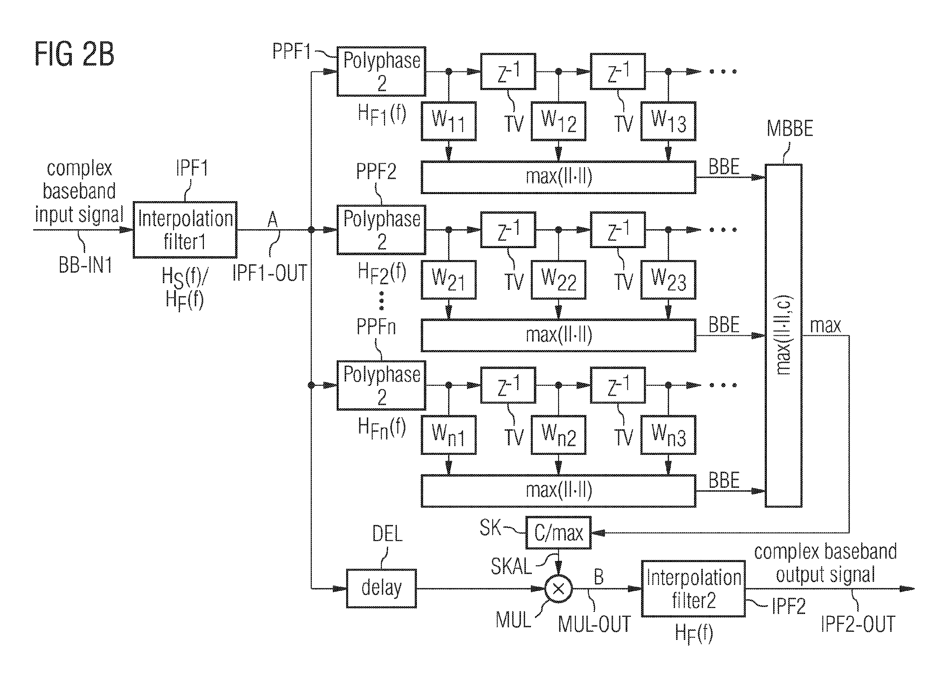

Die einzelnen Werte, die der jeweiligen Einheit BBE zur Betragsbildung zugeführt werden, können auch einzeln gewichtet werden. Bei dem in FIG 2 gezeigten Beispiel sind alle Wichtungsfaktoren $w_n = 1$ gleich gewählt.

Jedoch sind auch unterschiedliche Wichtungsfaktoren $w_n$ mit $w_n \leq 1$ möglich.

In einer besonders vorteilhaften Weiterbildung wird für die gesamten Verzögerungsketten ein mittlerer Wichtungsfaktor $w_n=1$ gewählt.

Die zu FIG 2a im wesentlichen identische Figur FIG 2b zeigt stellvertretend eine Wichtung mit Wichtungsfaktoren $w_{11}$, $w_{12}$, $w_{13}$ $w_{21}$ $w_{22}$, $w_{23}$ ..., $W_{n1}$, $W_{n2}$ und $w_{n3}$.

Die einzelnen Einheiten BBE zur Betragsbildung sind wiederum ausgangsseitig mit einer Einheit MBBE zur Maximumbildung bzw. zur Betragsmaximum-Bildung verbunden, die aus den zugeführten Werten und aus einem Wert c, der einen vorgegebenen Clipping-Schwellwert bildet, ein Maximum max ermittelt.

Dieses Maximum max wird einer Einheit SK zur Skalierung zugeführt, die einen Skalierungsfaktor SKAL = c/max berechnet.

Durch eine Einheit MUL wird das durch eine Einheit DEL zeitlich verzögerte Signal IPF1-OUT mit dem Skalierungsfaktor SKAL multipliziert. Dabei wird zum Ausgleich der Zeit, die für die Berechnung des Skalierungsfaktors SKAL benötigt wird, die als Verzögerungsglied ausgebildete Einheit DEL verwendet.

Durch die Einheit MUL wird ein skaliertes Ausgangssignal MUL-OUT gebildet, das der Einheit IPF2 zugeführt wird. Die Einheit IPF2 wiederum weist ebenfalls den oben beschriebenen Fehlerfrequenzgang $H_F$ (f) auf und ist als Interpolationsfilter ausgestaltet. Durch die Einheit IPF2 wird das Signal IPF2-OUT gebildet.

Zusammengefasst liegt nach jedem der Polyphasenfilter PPF1 bis PPFn das mit dem Faktor K überabgetastete und dem Frequenzgang des Sendefilters $H_S$ (f) versehene Signal an. Somit bieten die Polyphasenfilter die Möglichkeit einer Vorhersage, wann und wie stark der vorgegebene Clipping-Schwellwert c überschritten wird.

Aus den von den Polyphasenfiltern PPF1 bis PPFn gebildeten Zwischenwerten wird mit Hilfe der Zeitverzögerungselemente TV ein gleitendes Betragsmaximum $M_{gB}$ innerhalb des betrachteten Zeitintervalls gebildet.

Ist dieses Betragsmaximum $M_{gB}$ größer als ein gewünschter, voreingestellter Clipping-Schwellwert c ("Clipping Level"), so wird das verzögerte Signal IPF1-OUT mit einen Faktor = C / $M_{gB}$ mit Hilfe der Einheit SK gedämpft. Damit wird in der unmittelbaren Umgebung des jeweiligen Spitzenwertes eine angepasste, mit $w_n$ gewichtete Dämpfung mit dem Faktor C/$M_{gB}$ durchgeführt.

Die Einheit IPF2 erfüllt dabei gleichzeitig drei Aufgaben. Einerseits erfolgt eine Anpassung der Abtastrate an die Zwischenfrequenz. Andererseits wird der Frequenzgang des Sendesignals mit $H_2$ (f) = $H_F$ (f) auf einen Wert $H_1$ (f) * $H_2$ (f) = Hs(f) korrigiert.

Mit $H_1$ (f) = $H_S$ (f) / $H_F$ (f) und mit $H_2$ (f) - $H_F$ (f) folgt:

$$H_1(f) * H_2(f) = H_S(f),$$

so dass ein mit dem Sendefilter spektral geformtes Signal gebildet wird. Letztlich wird ein Fehler im Nutz-Frequenzbereich mit $H_2$(f) = $H_F$ (f) spektral geformt.

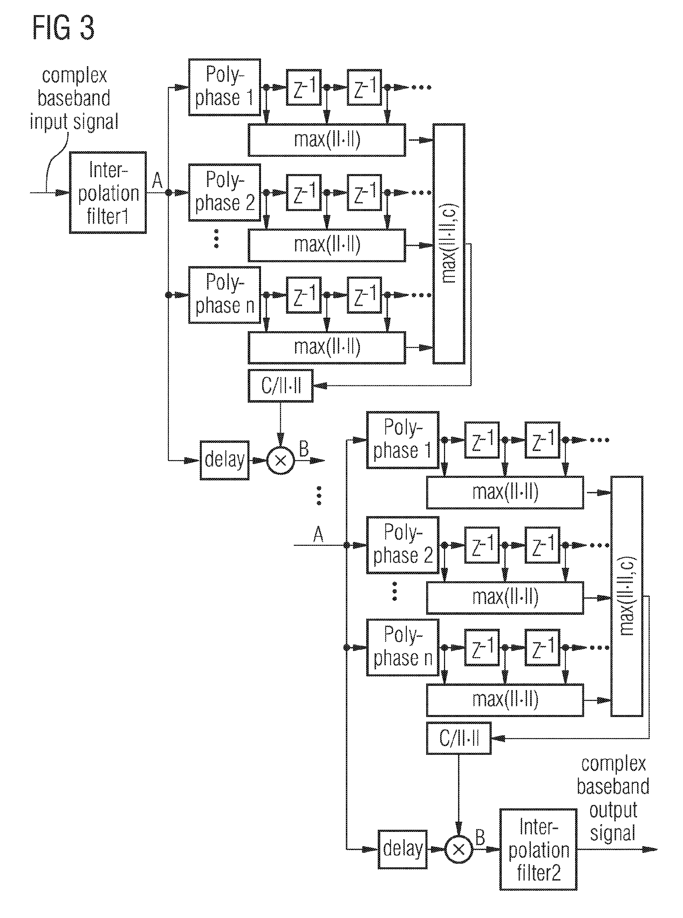

FIG 3 zeigt mit Bezug auf FIG 2 eine Kaskade zur Bildung eines komplexen Basisband-Ausgangssignals.

Dazu werden mit Bezug auf FIG 2 die beiden Einheiten IPF1 und IPF2 an den Punkten A und B abgetrennt. Der verbleibende dazwischen liegende Aufbau kann beliebig oft hintereinander in einer Kaskade geschaltet werden.

Insbesondere bei einer zweifachen Kaskade - wie hier dargestellt - ergibt sich hinsichtlich des zusätzlichen Aufwands der Kaskade beim Verhältnis PAPR eine besonders große Verbesserung.

Da es sich um komplexe Signale handelt, sind einige der erfindungsgemäßen Schritte sowohl mit reellen Signalkomponenten (Inphase-Komponente, I-Komponente) als auch mit imaginären Signalkomponenten (Quadratur-Komponente, Q-Komponente) auszuführen.

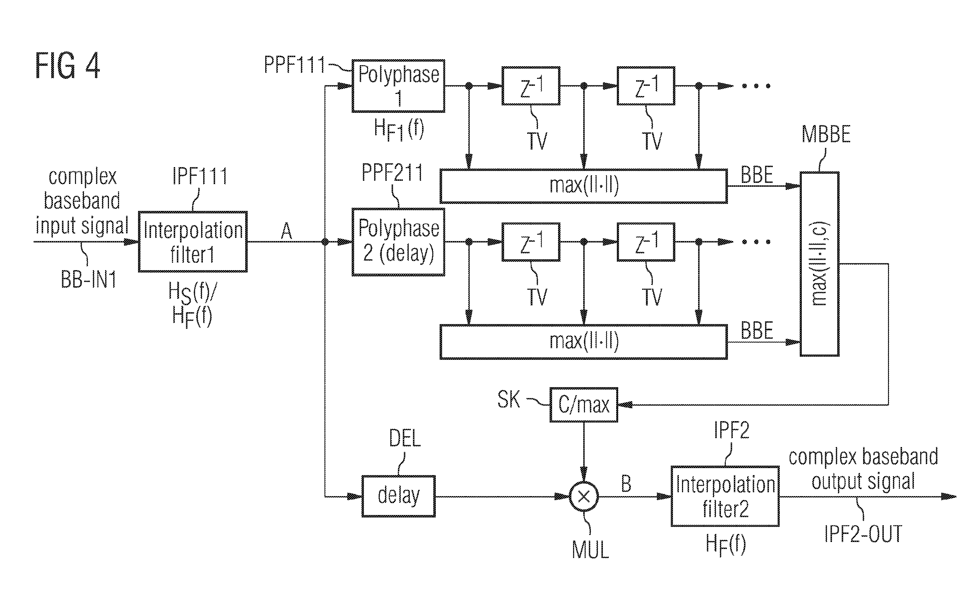

FIG 4 zeigt eine spezielle Implementierungsform der in FIG 2 gezeigten detaillierten Darstellung, bei der lediglich zwei Polyphasenfilter PPF111 und PPF211 verwendet werden.

Diese Polyphasenfilter sind als Interpolationsfilter mit vorab festgelegtem Fehlerfrequenzgang $H_F$(f) ausgebildet, mit dem auch ein beim Clippen entstehender Fehler gefiltert wird.

In FIG 4 ist die Vereinfachung dargestellt, wenn für den Fehlerfrequenzgang $H_F$(f) eine Halbbandfiltercharakteristik gewählt wird. Diese hat die Eigenschaft, dass mit Ausnahme eines einzigen Filterkoeffizienten, nämlich eines mittleren Filterkoeffizienten b1, jeder zweite Koeffizient den Wert "0" aufweist. Als Filterkoeffizienten ergeben sich beispielsweise:

a1 <u>0</u> a2 <u>0</u> a3 b1 a3 <u>0</u> a2 <u>0</u> a1.

Somit entfallen auf ein erstes Polyphasenfilter PPF111 diejenigen Filterkoeffizienten, die von "0" verschieden sind. Im oben genannten Beispiel sind dies die Filterkoeffizienten:

a1, a2, a3, a3, a2 a1.

Auf ein zweites Polyphasenfilter PPF211 entfallen diejenigen Filterkoeffizienten, deren Wert gleich "0" ist und der mittlere Filterkoeffizient b1. Damit entartet das zweite Polyphasenfilter PPF211 zu einer reinen Verzögerungsfunktion.

Dadurch, dass das Polyphasenfilter PPF211 zu einem reinen Laufzeitglied ausgebildet ist, sinkt der Implementierungsaufwand. Es verbleibt lediglich ein "echtes" Polyphasenfilter PPF111, das interpolierte Zwischenwerte liefert, die einer Überabtastung mit einem Faktor=2 entsprechen.

Bezüglich der Funktion der weiteren Einheiten wird auf die Beschreibung der FIG2 verwiesen.

Mit Bezug auf FIG 3 ist auch hier eine Kaskadierung des zwischen den Punkten A und B liegenden Schaltungsteils möglich.

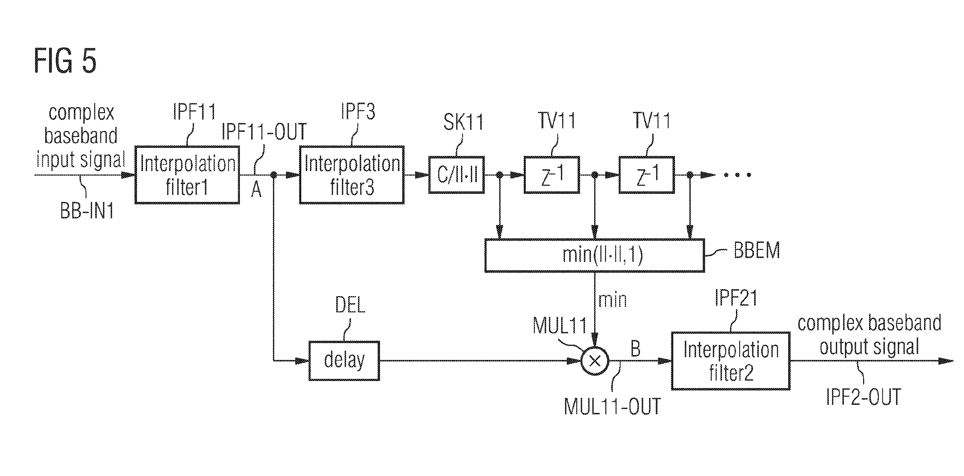

FIG 5 zeigt eine Bildung des trägerfrequenten Ausgangssignals in einer alternativen Ausgestaltungsform.

Die Einheit IPF21 ist als Interpolationsfilter mit vorab festgelegtem Fehlerfrequenzgang $H_F$ (f) ausgebildet, mit dem ein beim Clippen entstehender, Fehler gefiltert werden kann. Bei der Bestimmung des Fehlerfrequenzgangs $H_F$ (f) wird wieder davon Gebrauch gemacht, dass außerhalb eines verwendeten Nutz-Frequenzbereichs ein größerer Fehler tolerierbar ist, als innerhalb des Nutz-Frequenzbereichs. Dabei muss gleichzeitig das Fehlersignal außerhalb des Nutz-Frequenzbereichs so stark gedämpft werden, dass dort keine unzulässigen Störungen auftreten.

Zur spektralen Formung des Fehlers kann ein invertierter Frequenzgang eines Gegenstellen-Empfängers unter Berücksichtigung der jeweiligen Bandgrenzen des Nutz-Frequenzbereichs verwendet werden. Dadurch wird erreicht, dass der Fehler im Gegenstellen-Empfangssignal nach Passieren eines Empfangsfilters gleichverteilt im Frequenzspektrum vorliegt.

Alternativ dazu kann auch ein anderer Frequenzgang verwendet werden, wobei auch hier sicherzustellen ist, dass außerhalb des verwendeten Nutz-Frequenzbereichs keine unzulässigen Störungen auftreten.

Die Einheit IPF11 weist einen Frequenzgang $H_1(f)$ auf, der aus einem Frequenzgang $H_S(f)$ eines verwendeten Sendefilters und aus dem Fehlerfrequenzgang $H_F(f)$ wie folgt bestimmt wird:

$$H_1(f) = H_S(f) / H_F(f)$$

Das Eingangssignal BB-IN1 wird durch die Einheit IPF1 mit dem Frequenzgang $H_1(f)$ versehen bzw. gefiltert.

Zusätzlich erfolgt bereits hier eine Überabtastung des zugeführten Signals BB-IN1.

Durch eine als Interpolationsfilter ausgebildete Einheit IPF3 werden Vorschauwerte auf zu erwartende Signalüberschreitungen ermittelt, wobei die Einheit IPF3 einen Fehlerfrequenzgang $H_F(f)$ zur Filterung verwendet.

Der Einheit IPF3 ist eine Einheit SK11 nachgeschaltet, die im Rahmen einer vorläufigen Skalierung Normierungsfaktoren berechnet. Für jeden ihr zugeführten Signalwert wird ein Quotient aus der Clipping-Schwelle c einerseits und aus dem Betragsquadrat des Signals andererseits gebildet.

Unter Verwendung von zwei oder mehr Einheiten TV11, die zur Verzögerung verwendet werden, und einer Einheit BBEM wird ein Minimum aus einem Wert "1" und aus mehreren Normierungsfaktoren gebildet, wobei die Normierungsfaktoren zu den unterschiedlich verzögerten Signalwerten gehören. Dieses Minimum wird als Skalierungsfaktor min verwendet und der Einheit MUL 11 zugeführt.

Durch die Einheit MUL11 erfolgt durch Multiplikation eine Skalierung des durch eine Einheit DEL zeitlich verzögerten Ausgangssignals der Einheit IPF11 mit dem Skalierungsfaktor min.

Das derart skalierte Signal wird dann einer als Interpolationsfilter ausgebildeten Einheit IPF21 zugeführt, die es mit dem Fehlerfrequenzgang $H_F(f)$ filtert. Gegebenenfalls erfolgt hier eine erneute Überabtastung, um eine Signalumsetzung in den Zwischenfrequenzbereich ZF vorzubereiten. Durch die Einheit IPF21 wird das Signal IPF2-OUT gebildet.

Mit Bezug auf FIG 3 ist auch hier eine Kaskadierung des zwischen den Punkten A und B liegenden Schaltungsteils möglich.

In einer vorteilhaften Weiterbildung kann im Interpolationsfilter IPF3 eine Überabtastung auftreten, weil die Interpolationsfilter IPF3 und IPF21 identisch sind. In diesem Fall ist für das Interpolationsfilter IPF3 auch ein Vielfaches der Taktfrequenz erforderlich.

In der in FIG 2 gezeigten Polyphasenfilter-Ausführung ist die Anzahl der Filterkoeffizienten und Rechenoperationen genauso groß, allerdings bei einer niedrigeren Taktfrequenz. Die Polyphasenfilter-Ausführung stellt damit eine vorteilhafte Variante von FIG 5 dar.

**Patentansprüche**

1. Verfahren zur Vorverzerrung eines Basisband-Eingangssignals (BB-IN1),

   - bei dem das komplexe Basisbandeingangssignal (BB-IN1) mit einer Funktion $H_1(f)$ zur Bildung eines gefilterten ersten Signals (IPF1-OUT) gefiltert wird,
   - bei dem das gefilterte erste Signal (IPF1-OUT) zur Bildung eines vorverzerrten Signals (MUL-OUT) im Basisband mit einem Skalierungsfaktor (SKAL) multipliziert wird,
   - bei dem durch eine Signalanalyse des gefilterten ersten Signals (IPF1-OUT) betragsmäßige Signalüberschreitungen eines Schwellwertes c vorhergesagt werden, die zur Begrenzung des Basisbandsignals verwendet werden,
   - bei dem die Filterfunktion $H_1(f)$ als Quotient aus einem Frequenzgang $H_S(f)$ eines verwendeten Sendefilters einerseits und aus einem Fehlerfrequenzgang $H_F(f)$ andererseits berechnet wird und der Fehlerfrequenzgang $H_F(f)$ derart bestimmt wird, dass der mit $H_F(f)$ spektral geformte Fehler, der bei der Begrenzung des Basisbandsignals entsteht, eine frequenzabhängige Toleranz nicht überschreitet, und
   - bei dem das vorverzerrte Signal (MUL-OUT) mit dem Fehlerfrequenzgang $H_F(f)$ zur Bildung eines gefilterten zweiten Signals gefiltert wird.

2. Verfahren nach Anspruch 1, bei dem zur Bildung des gefilterten ersten Signals ein Interpolationsfilter verwendet wird.

3. Verfahren nach Anspruch 1, bei dem zur Bildung des gefilterten zweiten Signals ein Interpolationsfilter verwendet wird.

4. Verfahren nach Anspruch 1, bei dem zur Vorhersage der Signalabweichungen zumindest zwei Polyphasenfilter verwendet werden, an die jeweils das gefilterte erste Signal gelangt.

**5.** Verfahren nach Anspruch 4, bei dem Ausgangssignale der Polyphasenfilter innerhalb eines Betrachtungsintervalls gewichtet werden und aus den gewichteten Ausgangssignalen Maximalbeträge bestimmt werden.

**6.** Verfahren nach Anspruch 4, bei dem aus Ausgangssignalen der Polyphasenfilter innerhalb eines Betrachtungsintervalls Maximalbeträge bestimmt werden.

**7.** Verfahren nach Anspruch 5 oder 6, bei dem aus den Maximalbeträgen der Skalierungsfaktor bestimmt wird.

**8.** Verfahren nach einem der Ansprüche 1 bis 3, bei dem zur Vorhersage der Signalabweichungen ein Interpolationsfilter verwendet wird, an das das gefilterte erste Signal gelangt.

**9.** Verfahren nach Anspruch 8, bei dem aus einem Ausgangssignal des zur Vorhersage verwendeten Interpolationsfilters der Skalierungsfaktor bestimmt wird.

**10.** Verfahren nach einem der vorhergehenden Ansprüche,

- bei dem in einem Mehrfachträgerübertragungssystem aus jedem Basisbandsignal jeweils ein gefiltertes zweites Signal gebildet wird,
- bei dem jedes gefilterte zweite Signal durch Modulation in einen Zwischenfrequenzbereich umgesetzt wird,
- bei dem die modulierten zwischenfrequenten Signale zu einem Summensignal zusammengefasst werden und dieses Summensignal vorverzerrt wird, und
- bei dem das vorverzerrte Summensignal durch Modulation in ein trägerfrequentes Ausgangssignal umgesetzt wird.

**11.** Anordnung zur Vorverzerrung eines Basisband-Eingangssignals (BB-IN1),

- mit einem ersten Filter (IPF1), mit einer Vorhersageeinrichtung (PPF, TV, BBE, MBBE), mit einer Einrichtung zur Basisband-Vorverzerrung (MUL) und mit einem zweiten Filter (IPF2),
- bei der das erste Filter (IPF1) eine Filterfunktion $H_1$ (f) aufweist und an das erste Filter (IPF1) eingangsseitig das komplexe Basisbandeingangssignal (BB-IN1) angeschaltet ist, so dass aus dem Basisbandeingangssignal (BB-IN1) ein gefiltertes erstes Signal (IPF1-OUT) gebildet wird,
- bei der das erste Filter (IPF1) ausgangsseitig mit der Einrichtung zur Basisband-Vorverzerrung (MUL) verbunden ist, die aus dem gefilterten ersten Signal (IPF1-OUT) nach einer zeitlichen Verzögerung (DEL) durch Multiplikation mit einem Skalierungsfaktor (SKAL) ein vorverzerrtes Signal (MUL-OUT) bildet,

- bei der das erste Filter (IPF1) ausgangsseitig mit der Vorhersageeinrichtung (PPF, TV, BBE, MBBE) verbunden ist, die durch eine Signalanalyse des gefilterten ersten Signals (IPF1-OUT) Signalabweichungen bestimmt, die bei der Basisband-Vorverzerrung entstehen und die aus den vorhergesagten Signalabweichungen den Skalierungsfaktor (SKAL) für die Basisband-Vorverzerrung bestimmt,
- bei der die Filterfunktion $H_1$ (f) durch einen Quotienten aus einem Frequenzgang $H_S$ (f) eines verwendeten Sendefilters einerseits und aus einem Fehlerfrequenzgang $H_F$(f) andererseits festgelegt ist, wobei der Fehlerfrequenzgang $H_F$(f) derart bestimmt wird, dass der mit $H_F$(f) spektral geformte Fehler, der bei der Begrenzung des Basisbandsignals entsteht, eine frequenzabhängige Toleranz nicht überschreitet, und
- bei der die Einrichtung zur Basisband-Vorverzerrung (MUL) ausgangsseitig mit dem zweiten Filter (IPF2), das als Übertragungsfunktion den Fehlerfrequenzgang $H_F$ (f) aufweist, verbunden ist, so dass das vorverzerrte Signal (MUL-OUT) mit dem Fehlerfrequenzgang $H_F$(f) zur Bildung eines gefilterten zweiten Signals (IPF2-OUT) gefiltert wird.

**12.** Anordnung nach Anspruch 11, bei der das erste Filter (IPF1) und/oder das zweite Filter (IPF2) als Interpolationsfilter ausgebildet ist.

**13.** Anordnung nach Anspruch 11, bei der die Vorhersageeinrichtung zumindest zwei Polyphasenfilter (PPF1, PPF2, PPFn) aufweist, an die jeweils das gefilterte erste Signal (IPF1-OUT) eingangsseitig angeschaltet ist.

**14.** Anordnung nach Anspruch 13, bei der jedes Polyphasenfilter (PPF1, PPF2, PPFn) ausgangsseitig sowohl direkt als auch über mindestens ein Verzögerungsglied mit einer Betragsbildungseinrichtung (BBE) derart verbunden ist, dass innerhalb eines Betrachtungsintervalls aus den Ausgangssignalen des Polyphasenfilters ein Maximalbetrag bestimmt wird, wobei das Betrachtungsintervall durch das zumindest eine Verzögerungsglied bestimmt ist.

**15.** Anordnung nach Anspruch 13, bei der jedes Polyphasenfilter (PPF1, PPF2, PPFn) ausgangsseitig sowohl direkt als auch über mindestens ein Verzögerungsglied mit einer jeweils zugeordneten Wichtungseinheit verbunden ist und jede Wichtungseinheit ausgangsseitig mit einer Betragsbildungseinrichtung (BBE) derart verbunden ist, dass Ausgangssignale des Polyphasenfilters innerhalb eines Betrachtungsintervalls gewichtet werden und aus den gewichteten Signalen ein Maximalbetrag bestimmt wird, wobei das Betrachtungsintervall durch das zumindest eine Verzögerungsglied bestimmt ist.

16. Anordnung nach Anspruch 14 oder 15, bei der die den jeweiligen Polyphasenfiltern jeweils zuordenbaren Betragsbildungseinrichtungen ausgangsseitig mit einer Einrichtung zur Bestimmung eines maximalen Betragswert (MBBE) verbunden sind, so dass aus einzelnen Maximalbeträgen durch Vergleich mit einem wählbaren Clippingwert (c) ein Betragsmaximum und aus dem Betragsmaximum der Skalierungsfaktor (SKAL) bestimmt wird.

17. Anordnung nach Anspruch 11, bei der die Vorhersasageeinrichtung als Interpolationsfilter (IPF3) ausgestaltet ist.

18. Anordnung nach Anspruch 17, bei der die Vorhersageeinrichtung ausgangsseitig mit einer Skaliereinrichtung (SK11) verbunden ist, so dass aus den zugeführten Signalen des Interpolationsfilters (IPF3) durch Vergleich mit einem wählbaren Clippingwert (c) Skalierungswerte gebildet werden.

19. Anordnung nach Anspruch 18, bei der die Skaliereinrichtung (SK11) sowohl direkt als auch über mindestens ein Verzögerungsglied (TV11) mit einer Betragsbildungseinrichtung (BBEM) derart verbunden ist, dass innerhalb eines Betrachtungsintervalls aus den Skalierungswerten ein Minimalbetrag (min) als Skalierungsfaktor bestimmt wird, wobei das Betrachtungsintervall durch das zumindest eine Verzögerungsglied (TV11) bestimmt ist.

20. Anordnung nach einem der Ansprüche 10 bis 19,

    - bei der die Vorhersageeinrichtung und die Einrichtung zur Basiband-Vorverzerrung ingesamt n-fach kaskadiert werden,
    - bei der das gefilterte erste Signal an den Eingang der Kaskade geschaltet ist, und
    - bei der das vorverzerrte Signal über den Ausgang der Kaskade an das zweite Filter gelangt.

21. Anordnung nach Anspruch 14 oder 15, bei der die den jeweiligen Polyphasenfiltern jeweils zuordenbaren Betragsbildungseinrichtungen ausgangsseitig mit einer Einrichtung zur Bestimmung eines maximalen Betragswert (MBBE) verbunden sind, so dass aus einzelnen Maximalbeträgen durch Vergleich mit einem wählbaren Clippingwert (c) ein Betragsmaximum und aus dem Betragsmaximum der Skalierungsfaktor (SKAL) bestimmt wird.

22. Anordnung nach einem der vorhergehenden Ansprüche,

    - bei der in einem Mehrfachträgerübertragungssystem jedem Basisbandsignal jeweils ein gefiltertes zweites Signal zugeordnet ist,
    - bei der jedes gefilterte zweite Signal an einen Modulatoreingang angeschaltet ist, mit dessen Hilfe ein moduliertes Zwischenfrequenzsignal gebildet wird,
    - bei der die modulierten Zwischenfrequenzsignale an eine Summiereinrichtung (SUM11) gelangen, die diese zu einem Summensignal (ZF-SUM11) zusammenfasst,
    - bei der das Summensignal (ZF-SUM11) an eine Zwischenfrequenz-Vorverzerrungseinrichtung (IPF3) angeschaltet ist, und
    - bei der das vorverzerrte Summensignal an einen Modulator zur Bildung eines trägerfrequenten Ausgangssignals angeschaltet ist.

EP 1 753 145 A2

## FIG 1

complex
baseband
input signal

BB-IN1

IPF1

interpolation
filter1

IPF1-OUT

ATX

Approx. TX/
interpolation
filter

baseband
clipping

BBC-OUT

BBC

Error noise
shaping

interpolation
filter2

IPF2

IPF2-OUT

M1

ZF-OUT11

M2

ZF-OUT12

Mx

ZF-OUT1x

ZF-SUM11

SUM11

IPF3

ZF-OUT3

interpolation3,
IF clipping

interpolation4,
modulation

IPF4

RF output
signal

RF-OUT1

BB-IN2

BB-INx

FIG 2A

FIG 2B

EP 1 753 145 A2

## FIG 3

complex
baseband
input signal

# FIG 4

complex baseband input signal

BB-IN1

IPF111

Interpolation filter1

$H_S(f)/H_F(f)$

A

PPF111

Polyphase 1

$H_{F1}(f)$

PPF211

Polyphase 2 (delay)

$Z^{-1}$  TV

$Z^{-1}$  TV

$\cdots$

$Z^{-1}$  TV

$Z^{-1}$  TV

$\cdots$

$\max(\|\cdot\|)$

BBE

$\max(\|\cdot\|)$

BBE

MBBE

$\max(\|\cdot\|;c)$

SK

C/max

DEL

delay

MUL

$\times$

B

IPF2

Interpolation filter2

$H_F(f)$

complex baseband output signal

IPF2-OUT

EP 1 753 145 A2

## FIG 5

complex baseband input signal → [Interpolation filter1 (IPF11)] --A--→ [Interpolation filter3 (IPF3)] → [C/‖·‖ (SK11)] → [z⁻¹ (TV11)] → [z⁻¹ (TV11)] → · · ·

BB-IN1

IPF11-OUT

The three tap outputs feed → [min(‖·‖,1) (BBEM)]

min → 

A → [delay (DEL)] → (×) (MUL11) --B--→ [Interpolation filter2 (IPF21)] → complex baseband output signal

MUL11-OUT

IPF2-OUT

EP 1 753 145 A2

EP 1 753 145 A2

## FIG 6

## FIG 7